# EUROPEAN PATENT SPECIFICATION

(11) **EP 4 551 731 B1**
(45) Date of publication and mention of the grant of the patent: **01.04.2026**
(21) Application number: 23745632.2
(22) Date of filing: 05.07.2023
(51) Int. Cl.: C23C 14/34, C23C 14/35, H01J 37/34

(54) **A HIGH-RATE MAGNETRON SPUTTERING DEVICE**
MAGNETRON-ZERSTÄUBUNGSVORRICHTUNG MIT HOHER GESCHWINDIGKEIT
DISPOSITIF DE PULVÉRISATION À MAGNÉTRON À HAUT DÉBIT

(30) Priority: 06.07.2022 LV 220059
(43) Date of publication of application: 14.05.2025
(73) Proprietor: Naco Technologies, SIA, 1005 Riga (LV)
(72) Inventor: MITIN, Valery, 1005 Riga (LV); KOVALENKO, Vladimirs, 1005 Riga (LV); NAZAROVS, Pavels, 1005 Riga (LV); LENCEVSKIS, Vladimirs, 1005 Riga (LV)
(74) Representative: Vitina, Maruta
(86) International application number: PCT/IB2023/056949
(87) International publication number: WO 2024/009229

(56) References cited:
- JP-A- S59 215 484
- US-A- 4 169 031
- US-A1- 2004 140 204

## Description

The invention relates to the technique of vacuum deposition of metal and ceramiccoatings, in particular to a device for high-rate magnetron sputtering, and can be used in the manufacture of coated products made out of metals, glass, polymer films and fabric.

There are known devices for vacuum deposition of coatings by magnetron sputtering, in which the sputtering target is above the magnetic system [Patent RU2107971, C23C 14/35, 1998]. Such devices have relatively low coating deposition rates (5 nm/s), since the target is sputtered mainly in a narrow zone, which leads to its local overheating at high appliedpower. In turn, this leads to thermomechanical stresses and bending of the target, and as a result to the failure of the magnetron structure.

The traditional (conventional) magnetron does not allow efficient sputtering of targets from both non-magnetic and magnetic materials at high rates. The ultimate power density of the plasma discharge of such the magnetron, which directly characterizes the rate of sputtering of the material, does not reach 20-30 W/cm².

The reason for the low sputtering rate using the traditional magnetron is related to the design of the cathode assembly and the cooling pattern of the target or the copper base on which the target is mounted. The coolant (water) is supplied, usually, to the cavity between the poles of the magnetic system and is merged from this cavity according to the scheme of an inlet on one side and outlet on the opposite side at the same pressure of 3-6,1 bar (3-6 atm). With this delivery pattern, the surface of the target in the maximum erosion (sputtering) zone is cooled by the passing flow of the coolant, the velocity of which is small due to the constant pressure in the system. As discharge power density increases, the target surface temperature and heat flux increase. To remove heat, the coolant in the cavity under the target should intensively wash the surface in the zone of maximum erosion. If the flow rate of water is insignificant, the cooling is weak and steam bubbles form on the surface, the water boils and the target material may melt.

There are known the designs of planar sputtering magnetrons, in which the elements of the magnetic system and the sputtering target, or the upper cover of the magnetron on which the sputtering target is mounted, are in direct contact with the coolant [U.S. Patent US4434042A]. The main disadvantage of such a design is the need to install an elastic seal between the top cover and the magnetron housing, which limits the maximum temperature of the sputtering targets and significantly reduces the reliability of the entire device. Moreover, a significant pressure difference between the working chamber and the coolant requires an increase in rigidity and, as a consequence, the thickness of the upper cover of the magnetron, especially when designing planar magnetrons of large area, which reduces the magnetic field strength on the target surface and, as a consequence, the thickness of the sputtering targets. Another disadvantage of such a design, when a flow-through water is used as a coolant, is the high probability of electrochemical corrosion of the magnetic system elements.

There is known a magnetron design with direct cooling of the target, in which the coolant circulates through special channels formed in the target body [Patent US5985115A]. The main disadvantage of such systems is the complexity of making and changing targets, as well as the impossibility of forming channels in ceramic targets.

All these disadvantages altogether do not allow from the point of view of the developers of devices for magnetron sputtering to significantly increase the energy characteristics - the density of the plasma discharge power and, accordingly, the sputtering rate of the target material and the rate of coating deposition.

There is known a balanced magnetron, which was used as part of an in-chamber system for high-rate deposition of multicomponent film coatings [Patent RU2379378]. In the design of this magnetron with direct cooling of the sputtering target for its intensive cooling, the flow of the coolant was passed through the gap between the poles of the magnetic system. This made it possible to increase the power density of the plasma discharge from 20-30 W/cm² to 150 W/cm² in real examples of sputtering of multicomponent targets (the patent claims the possibility of achieving a maximum power density of 500 W/cm²). Despite the fact that this solution made it possible to increase the efficiency of the coolant flow over the cooled surface of the target, it did not exclude the mechanical effect of the coolant pressure on the target (pressure in the closed recirculation cooling system is 4,1-5.1 bar (4-5 atm)) and did not significantly increase the velocity of its flow in the slot. The problem of vaporization on the cooled surface when high electric power is applied to the discharge in this solution is not completely excluded.

The closest prior art is the design [US 2004/140204 A1] of a circular planar magnetrons with a central water inlet comprising an anode, a body of magnetron cathode with a cooled cavity, a balanced magnetic system placed inside the cooled cavity, comprising a peripheral magnetic pole, a central magnetic pole interconnected by a magnetic core made of a soft magnetic material, over which a sputtering target is mounted through a vacuum seal on a thin-sheet cooled base, and a cooling system of the sputtering target and the body of the magnetron cathode is structurally connected to the magnetron magnetic system, the cooling system of the sputtering target and the body of the magnetron cathode is configured with a coolant inlet into the body of the magnetron cathode to the cooled surface of the sputtering target mounted on the thin-sheet cooled base through an opening in the central magnetic pole.

The technical problem solved by the present invention is the creation of a device for high-rate magnetron sputtering, having a high coating depositionrate at a reduced thermal and mechanical load on the sputtering target.

In a device for a high-rate magnetron sputtering device comprising an anode, a body of a magnetron cathode with a cooled cavity, a balanced magnetic system placed inside the cooled cavity, comprising a peripheral magnetic pole and a central magnetic pole interconnected by a magnetic core made of a soft magnetic material, over which a sputtering target is mounted through a vacuum seal on a thin-sheet cooled base, and a cooling system of the sputtering target and the body of the magnetron cathode is structurally connected to the magnetron magnetic system, wherein the cooling system of the sputtering target and the body of the magnetron cathode is configured with a coolant inlet into the body of the magnetron cathode to the cooled surface of the sputtering target mounted on the thin-sheet cooled base through an opening in the central magnetic pole, according to the present invention, the balanced magnetic system comprises an inter-pole spacer insert interconnected by the magnetic core made of a soft magnetic material with the peripheral magnetic pole and the central magnetic pole, at the end of the central magnetic pole there is a radial manifold with slots in the form of flat nozzles designed for sputtering at their outlet of the coolant in the form of a high-rate flow from separate jets, and with a drain of the coolant from the cooled cavity into the atmosphere through a system of holes in the inter-pole spacer insert, radially located in it above the cooled surface of the sputtering target, wherein the cooling system is configured such that the pressure of the coolant in the cooled cavity of the body of the magnetron cathode falls from 4.1-6.1 bar (4-6 atm) at the inlet of the coolant to 0.8-1.2 bar (0.8-1.2 atm) on the drain of the coolant.

Such a technical solution for supplying the coolant to the cooling zone on the cooled surface of the sputtering target allows it to be cooled intensively, at a high rate and evenly, preventing the formation of steam bubbles on the cooled surface of the sputtering target and removing the heated coolant from the cavity into the atmosphere, and due to a large pressure drop in the cooled cavity, the mechanical pressure on the surface of the target is significantly reduced.

In the high-rate magnetron sputtering device, the central magnetic pole of the magnetron magnetic system is an extension of the magnetic core made of a magnetically soft material, and the magnetic field source is the peripheral magnetic pole of a magnetic rigid material selected from the group consisting of magnetic material alloys, SmCo₅, barium ferrite, strontium ferrite, and neodymium-iron-boron composite.

In the device with a cylindrical sputtering target, the inner diameter of the cooled cavity of the magnetron cathode body with the cylindrical sputter target has a diameter of 25-120 mm.

In the device with a rectangular sputtering target, the cooled cavity of the magnetron cathode body with the rectangular long sputter target is made with a width of 50-120 mm and a length of not more than 700 mm. These size limitations are also related to the pressure factor on the target.

The end surface of the inter-pole spacer insert of the magnetron magnetic system, which serves as a limiter of the volume of the cooled cavity between the peripheral magnetic pole and the central magnetic pole and faces the cooled surface of the sputter target, is made of heat-resistant plastic in the form of a turbine impeller. This serves to better cool the surface of the sputtering target, as coolant flows over it and is removed quickly.

As a result of using the present invention, it becomes possible to sputter targets not only from mechanically strong and dense materials, but also from ductile, brittle and porous ones using thin copper membranes, to which targets from these materials are soldered, glued with a conductive adhesive, or mechanically pressed to ensure tight contact. In this case, the use of intermediate thick-walled slabs of copper, on which porous or with low mechanical strength targets are usually attached, is almost completely excluded. The use of thin copper membranes also contributes to good heat removal from the target.

The invention is explained in more detail below with reference to the accompanying drawings, wherein are shown:
Fig.1 - a device for a high-rate magnetron sputtering;
Fig.2 - the appearance of a high-rate magnetron sputtering device of DK-100 type mounted on a flange of a vacuum coating installation of NACO-600 type;
Fig. 3 -a spacer insert with a surface in the form of an impeller;
Fig. 4 - a spacer insert with a smooth surface;
Fig. 5 - curves of volt-ampere characteristics (CVC) when sputtering targets made of copper, aluminum, titanium and stainless steel using the high-rate magnetron sputtering device of DK-100 type.

The present invention is explained by examples of its specific implementation.

### Example 1.

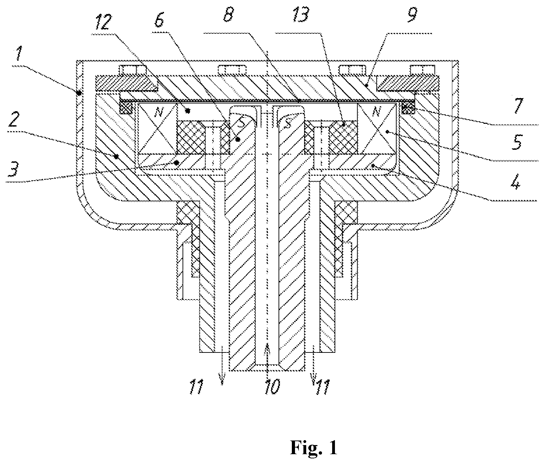

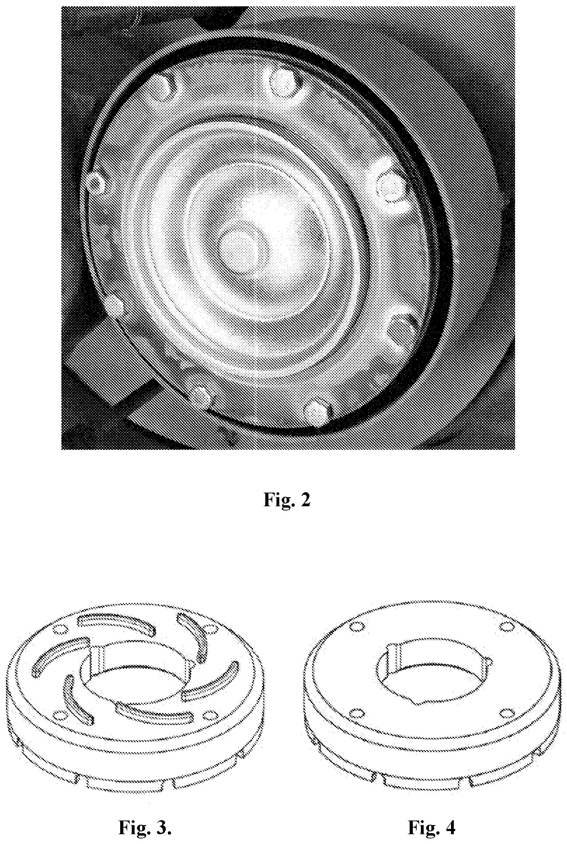

For the practical testing of the operation of the high-rate magnetron sputtering device, a sputtering system of the DK-100 type was manufactured, schematically represented in FIG. 1. Fig. 2 is a photograph of its appearance.

Device for high-rate magnetron sputtering (Fig. 1) includes an anode 1, a body 2 of a magnetron cathode with a cooled cavity 12, a balanced magnetic system 3 with a magnetic core 4 of soft magnetic iron and a peripheral magnetic pole 5 of SmCo₅ with a central magnetic pole 6 of magneticallysoft armco iron, placed inside the cooled cavity 12. In the center of the central magnetic pole 6, a hole is drilled for a coolant- water inlet 10 (flow). Radial slots in the form of flat nozzles are milled at the end of the central magnetic pole 6. The nozzles are designed for uniform sputtering of the coolant in the form of separate jets, with a high speed flow over the cooled surface of the sputtering target 9 in the form of a disk with a diameter of 98 mm and a thickness of 8 mm, which is installed on the cathode body 2 through a vacuum seal 7. To press the coolant flow to the cooled surface of the target 9 and its intensive mixing between the poles, a spacer insert 13 is located, the end surface of which, serving as a limiter of the volume of the cooled cavity 12 between the peripheral magnetic pole 5 and the central magnetic pole 6 and facing the cooled surface of the sputtering target 9, is made of heat-resistant plastic in the form of a turbine impeller (Fig.3). The cooling system of the sputtering target 9 and the body 2 of the magnetron cathode is made with an inlet 10 of the coolant into the body 2 of the magnetron cathode to the cooled surface of the sputtering target 9, if it is made of a dense metal. In the case of brittle and porous materials, the target is mounted on a copper thin-sheet cooled base 8. The coolant through the hole in the central magnetic pole 6, on the end of which there is a radial manifold with slots in the form of flat nozzles, is sprayed in the form of a high-rate flow from separate jets which are swirled in the space between the surface of the target 9 and magnetic poles 5 and 6, and the coolant mixed with vapour bubbles washed off by it from the surface of the target 9, is drained into the atmosphere through the drain 11 of the coolant from the cooling cavity 12 through a system of holes in the spacer insert 13, radially located in it above the cooled surface of the spraying zone of the target, wherein the cooling system is configured such that the pressure of the coolant in the cooled cavity 12 of the body 2 of the magnetron cathode drops from 4.1-6.1 bar (4-6 atm) at the inlet 10 of the coolant to 0.8-1.2 bar (0.8-1.2 atm) when the coolant 11 is drained. The inner diameter of the cooled cavity 12 of the body 2 of the magnetron cathode with a cylindrical sputtering target 9 has a diameter of 100 mm.

Targets were used for the test in the device described in Example 1:
- of copper with a purity of 99.9 wt%, with a thermal conductivity of 401 W/m·K;
- of aluminum with a purity of 99.998%, with a thermal conductivity of 209 W/m·K;
- of titanium with a purity of 99.998%, with a thermal conductivity of 29.9 W/m·K;
- of stainless steel type 18-10 (316L), with a thermal conductivity of 17.5 W/m·K.

The working chamber of the NACO-600 device in which the high-rate magnetron sputtering device is mounted (Fig.2), is pumped out to a pressure of 0.005 Pa. The working gas Ar is fed into the chamber until the pressure increases to 0.5 Pa, and the starting voltage of 1100 V is fed to the cathode 2 of the magnetron. A plasma discharge localised on its surface by a magnetic field is initiated at the target 9. The area of discharge localisation on all targets of sputtered 4 materials is 22cm².

### Copper Target sputtering

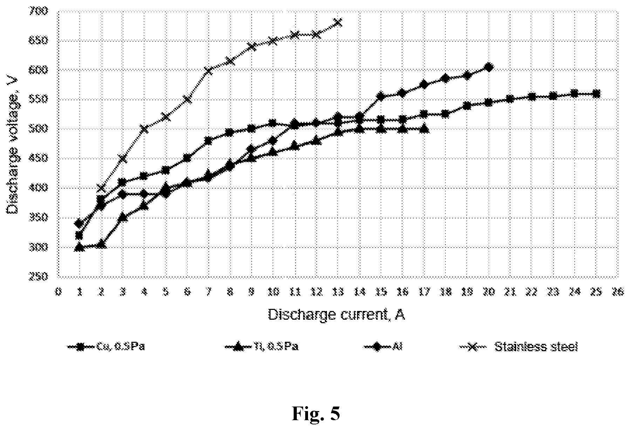

When the plasma discharge is ignited on the copper target 9 at a current of 1 A, the discharge voltage decreases to 320 V and then, when power is introduced into the plasma discharge, the current and discharge voltage increase stepwise, see the volt-ampere characteristic of the plasma discharge (CVC) in Fig. 5. With a discharge current of 5 A, the discharge voltage is set to 420 V, which corresponds to a discharge power density of 95.45 W/cm² (5A x420 V = 2100 W/22cm²= 95.45 W/cm²); with a discharge current of 8 A, a discharge voltage of 500 V, a power density of 181.82 W/cm², a coolant-water temperature is at the inlet to the cooled magnetron body of 18 °C, and at the outlet of 24 °C; the maximum discharge parameters achieved on the copper target were achieved during the test are: discharge current of 25 A, discharge voltage of 550 V, a discharge power density of 625 W/cm², a water temperature at the inlet of 18 °C, and at the outlet of 40 °C. Target surface material is not melted. This is the maximum DC magnetron discharge power density achieved by effective cooling for a given device type and size when a copper target is sputtered. The sputtering/coating rate at these power density values is 10-15 times faster than magnetron sputtering with a conventional device. The achieved power density value of 625 W/cm² for a magnetron discharge in continuous DC sputtering mode is record-breaking and the obtained result proves the effective cooling of the sputtering target in this device.

### Aluminum Target Sputtering

When igniting a discharge on an aluminum target (ductile material) at a current of 1 A, the discharge voltage is 340 V and the power density is 15 W/cm², see CVC, FIG. 5. With the input of power, the maximum achieved parameters when sputtering an aluminum target 9 are: discharge current 20 A, discharge voltage 610 V, power density 554.54 W/cm², water temperature at the inlet 18° C, and at the outlet 35° C. The material (aluminum) on the surface of the target is not melted. This is the maximum magnetron discharge power density for a given device type and size when sputtering the aluminum target.

### Titanium target sputtering.

When igniting a discharge on a titanium target at a current of 1 A, the discharge voltage is 300 V and the power density is 13.63 W/cm², see CVC, FIG. 5. With the input of power, the maximum achieved parameters with the sputtering of a titanium target 9 are: discharge current of 17.5 A, discharge voltage of 490 V, power density of 389.8 W/cm², water temperature at the inlet of 18 °C, and at the outlet of 30 °C. The material (titanium) on the target surface has melting marks. This is the maximum magnetron discharge power density for a given device size when sputtering the titanium target. In this case, the low thermal conductivity of titanium is the threshold for increasing the power of the magnetron discharge.

### Stainless steel target sputtering

The steady-state sputtering process of the stainless steel target 9 begins at a discharge current of 2A and a voltage of 400 V, which corresponds to a power density of 36.36 W/cm². With the subsequent input of power, the volt-ampere characteristic of the discharge is steeper than that of the copper, aluminum, and titanium targets, see Fig. 5 and current thresholds of 13.5 A are reached at a voltage of 680 V, with a power density of 417.3 W/cm². A further increase in power leads to a sharp increase in the discharge voltage.

The outlet water temperature has increased to 45°C, and the material on the target surface has a melted track in the center of maximum erosion. This melting is due to surface overheating due to the low thermal conductivity of stainless steel. However, the target remains operational at high sputtering parameters.

### Example 2

The device for high-speed magnetron sputtering is made as described in Example 1, except that the cooled cavity 12 of the body 2 of the magnetron cathode with a rectangular extended sputtering target 9 is made with a width of 70 mm and a length of 350 mm.

### Example 3

The device for high-speed magnetron sputtering is made as described in Example 1, except that the end surface of the inter-pole spacer 13 of the magnetron magnetic system 3, which serves as a limiter of the volume of the cooled cavity 12 between the peripheral magnetic pole 5 and the central magnetic pole 6 and faces the cooled surface of the sputtering target 9, is made smooth (Fig. 4).

## Claims

1. A high-rate magnetron sputtering device comprising an anode (1), a body (2) of a magnetron cathode with a cooled cavity (12), a balanced magnetic system (3) placed inside the cooled cavity (12), comprising a peripheral magnetic pole (5) and a central magnetic pole (6) interconnected by a magnetic core (4) made of a soft magnetic material, over which a sputtering target (9) is mounted through a vacuum seal (7) on a thin-sheet cooled base (8), and a cooling system of the sputtering target (9) and the body (2) of the magnetron cathode is structurally connected to the magnetron magnetic system,
wherein, the cooling system of the sputtering target (9) and the body (2) of the magnetron cathode is configured with a coolant inlet (10) into the body (2) of the magnetron cathode to the cooled surface of the sputtering target (9) mounted on the thin-sheet cooled base (8) through an opening in the central magnetic pole (6),
**characterized in that** the balanced magnetic system (3) comprises an inter-pole spacer insert (13) interconnected by the magnetic core (4) made of a soft magnetic material with the peripheral magnetic pole (5) and the central magnetic pole (6), at the end of the central magnetic pole (6) there is a radial manifold with slots in the form of flat nozzles designed for sputtering at their outlet of the coolant in the form of a high-rate flow from separate jets, and with a drain (11) of the coolant from the cooled cavity (12) into the atmosphere through a system of holes in the inter-pole spacer insert (13), radially located in it above the cooled surface of the sputtering target (9), wherein the cooling system is configured such that the pressure of the coolant in the cooled cavity (12) of the body (2) of the magnetron cathode falls from 4.1 bar to 6.1 bar at the inlet (10) of the coolant to 0.8 bar to 1.2 bar on the drain (11) of the coolant.

2. The device according to claim 1, **characterized in that** the central magnetic pole (6) of the magnetron magnetic system (3) is an extension of the magnetic core (4) made of a magnetically soft material, and the magnetic field source is the peripheral magnetic pole (5) of a magnetic rigid material selected from the group consisting of magnetic material alloys, SmCo₅, barium ferrite, strontium ferrite, and neodymium-iron-boron composite.

3. The device according to claim 1, **characterized in that** the inner diameter of the cooled cavity (12) of the magnetron cathode body (2) with the cylindrical sputter target (9) has a diameter of 25-120 mm.

4. The device according to claim 1, **characterized in that** the cooled cavity (12) of the magnetron cathode body (2) with the rectangular long sputter target (9) is made with a width of 50-120 mm and a length of not more than 700 mm.

5. The device according to claim 1, **characterized in that** the end surface of the inter-pole spacer insert (13) of the magnetron magnetic system (3), which serves as a limiter of the volume of the cooled cavity (12) between the peripheral magnetic pole (5) and the central magnetic pole (6) and faces the cooled surface of the sputter target (9), is made of heat-resistant plastic in the form of a turbine impeller.

## Patentansprüche

1. Hochleistungs-Magnetron-Sputteranlage, unfassend eine Anode (1), einen Magnetron-Kathodenkörper (2) mit einem gekühlten Hohlraum (12), ein im gekühlten Hohlraum (12) angeordneten, ausbalancierten Magnetsystem (3) mit einem peripheren Magnetpol (5) und einem zentralen Magnetpol (6), die durch einen Magnetkern (4) aus weichmagnetischem Material verbunden sind, auf dem ein Sputtertarget (9) mittels einer Vakuumdichtung (7) auf einem dünnblechgekühlten Träger (8) montiert ist, und ein Kühlsystem für das Sputtertarget (9) und den Magnetron-Kathodenkörper (2), das strukturell mit dem Magnetron-Magnetsystem verbunden ist,
wobei das Kühlsystem für das Sputtertarget (9) und den Magnetron-Kathodenkörper (2) so ausgestattet ist, dass das Kühlmittel über einen Eingang (10) in den Magnetron-Kathodenkörper (2) zur gekühlten Oberfläche des auf einer dünnblechgekühlten Basis (8) montierten Sputtertargets (9) durch eine Öffnung im zentralen Magnetpol (6) geleitet wird,
**dadurch gekennzeichnet, dass** das ausbalancierte Magnetsystem (3) einen Zwischenpol-Abstandshalter (13) umfasst, der über den aus weichmagnetischem Material bestehenden Magnetkern (4) mit dem peripheren Magnetpol (5) und dem zentralen Magnetpol (6) verbunden ist, am Ende des zentralen Magnetpols (6) ein radialer Verteiler mit Schlitzen in Form flacher Düsen sich befindet, die zum Sputtern des Kühlmittels an ihrem Austritt als Hochgeschwindigkeitsstrom aus separaten Strahlen dienen, der Kühlmittelauslass (11) das Kühlmittel aus dem Kühlraum (12) durch ein System von Öffnungen im Zwischenpol-Abstandshalter (13) in die Atmosphäre führt, dieser Austritt radial oberhalb der gekühlten Oberfläche des Sputtertargets (9) sich befindet, wobei das Kühlsystem so ausgestattet ist, dass der Kühlmitteldruck im Kühlraum (12) des Magnetron-Kathodenkörpers (2) von 4,1 bar bis 6,1 bar am Kühlmitteleinlass (10) auf 0,8 bar bis 1,2 bar am Kühlmittelauslass (11) abfällt.

2. Die Sputteranlage nach Anspruch 1, **dadurch gekennzeichnet, dass** der zentrale Magnetpol (6) des Magnetronsystems (3) eine Verlängerung des Magnetkerns (4), hergestallten aus einem weichmagnetischen Material, ist und die Magnetfeldquelle der periphere Magnetpol (5) ist, der aus einem hartmagnetischen Materialhergestallt hergestallt ist, das aus der Gruppe bestehend aus Magnetlegierungen, SmCo₅, Bariumferrit, Strontiumferrit und Neodym-Eisen-Bor-Verbundwerkstoff ausgewählt ist.

3. Die Sputteranlage nach Anspruch 1, **dadurch gekennzeichnet, dass** der Innendurchmesser des gekühlten Hohlraums (12) des Magnetron-Kathodenkörpers (2) mit dem zylindrischen Sputtertarget (9) 25-120 mm beträgt.

4. Die Sputteranlage nach Anspruch 1, **dadurch gekennzeichnet, dass** der gekühlte Hohlraum (12) des Magnetron-Kathodenkörpers (2) mit dem rechteckigen, länglichen Sputtertarget (9) eine Breite von 50-120 mm und eine Länge von höchstens 700 mm aufweist.

5. Die Sputteranlage nach Anspruch 1, **dadurch gekennzeichnet, dass** die Endfläche des Zwischenpol-Abstandshalters (13) des Magnetron-Magnetsystems (3), der als Begrenzer des Volumens des gekühlten Hohlraums (12) zwischen dem peripheren Magnetpol (5) und dem zentralen Magnetpol (6) dient und der gekühlten Oberfläche des Sputtertargets (9) zugewandt ist, aus hitzebeständigem Kunststoff in Form eines Turbinenlaufrads hergestallt ist.

## Revendications

1. Dispositif de pulvérisation cathodique magnétronique à haut débit comprenant une anode (1), un corps (2) de cathode du magnétron doté d'une cavité refroidie (12), un système magnétique équilibré (3) placé à l'intérieur de la cavité refroidie (12), comprenant un pôle magnétique périphérique (5) et un pôle magnétique central (6) interconnectés par un noyau magnétique (4) en matériau magnétique doux, sur lequel une cible de pulvérisation (9) est montée par l'intermédiaire d'un joint sous vide (7) sur une base refroidie en feuille mince (8), et un système de refroidissement de la cible de pulvérisation (9) et du corps (2) de la cathode du magnétron étant structurellement connecté au système magnétique magnétronique,
dans lequel le système de refroidissement de la cible de pulvérisation (9) et du corps (2) de la cathode du magnétron est configuré avec une entrée de fluide de refroidissement (10) dans le corps (2) de la cathode du magnétron vers la surface refroidie de la cible de pulvérisation (9) montée sur la base refroidie en feuille mince (8) à travers une ouverture dans le pôle magnétique central (6),
**caractérisé en ce que** le système magnétique équilibré (3) comprend un insert d'espacement interpolaire (13) interconnecté par le noyau magnétique (4) fait d'un matériau magnétique doux avec le pôle magnétique périphérique (5) et le pôle magnétique central (6), à l'extrémité du pôle magnétique central (6) se trouve un collecteur radial avec des fentes en forme de buses plates conçues pour la pulvérisation à leur sortie du fluide de refroidissement sous la forme d'un flux à haut débit provenant de jets séparés, et avec un drain (11) du fluide de refroidissement de la cavité refroidie (12) dans l'atmosphère à travers un système de trous dans l'insert d'espacement interpolaire (13), situé radialement dans celui-ci au-dessus de la surface refroidie de la cible de pulvérisation (9), dans lequel le système de refroidissement est configuré de telle sorte que la pression du fluide de refroidissement dans la cavité refroidie (12) du corps (2) de la cathode du magnétron tombe de de 4,1 bar à 6,1 bar à l'entrée (10) du fluide de refroidissement à de 0,8 bar à 1,2 bar au drain (11) du fluide de refroidissement.

2. Le dispositif selon la revendication 1, **caractérisé en ce que** le pôle magnétique central (6) du système magnétique magnétronique (3) est une extension du noyau magnétique (4) constitué d'un matériau magnétiquement doux, et la source du champ magnétique est le pôle magnétique périphérique (5) d'un matériau magnétique rigide choisi parmi le groupe constitué d'alliages de matériaux magnétiques, de SmCo₅, de ferrite de baryum, de ferrite de strontium et de composite néodyme-fer-bore.

3. Le dispositif selon la revendication 1, **caractérisé en ce que** le diamètre intérieur de la cavité refroidie (12) du corps de cathode du magnétron (2) avec la cible de pulvérisation cylindrique (9) a un diamètre de 25 à 120 mm.

4. Le dispositif selon la revendication 1, **caractérisé en ce que** la cavité refroidie (12) du corps de cathode du magnétron (2) avec la cible de pulvérisation rectangulaire longue (9) est réalisée avec une largeur de 50 à 120 mm et une longueur ne dépassant pas 700 mm.

5. Le dispositif selon la revendication 1, **caractérisé en ce que** la surface d'extrémité de l'insert d'espacement interpolaire (13) du système magnétique du magnétron (3), qui sert de limiteur du volume de la cavité refroidie (12) entre le pôle magnétique périphérique (5) et le pôle magnétique central (6) et fait face à la surface refroidie de la cible de pulvérisation (9), est fabriquée en plastique résistant à la chaleur sous la forme d'une roue de turbine.
